# DEMANDE DE BREVET EUROPEEN

(11) **EP 1 047 294 A1**
(43) Date de publication de la demande: **25.10.2000**
(21) Numéro de dépôt: 99108065.6
(22) Date de dépôt: 23.04.1999
(51) Int. Cl.: H05K 7/20

(54) **Substrat métallique isolé pour circuits imprimés**

(71) Demandeur: The Swatch Group Management Services AG, 2501 Biel (CH)
(72) Inventeur: Abdul-Hamid, Kayal, 2000 Neuchâtel (CH)
(74) Mandataire: Ravenel, Thierry Gérard Louis

(57) **Abrégé**

La présente invention est relative à un substrat (1) susceptible de recevoir un arrangement électrique en circuit imprimé (2) et comportant un substrat de base (11; 11A) réalisé en un matériau métallique thermiquement conducteur sur une face duquel sont disposés des moyens (12) destinés, d'une part, à isoler électriquement l'arrangement électrique en circuit imprimé du substrat de base, et, d'autre part, à assurer un transfert vers le substrat de base (11; 11A) de la chaleur dissipée par des composants électroniques (3) montés sur l'arrangement électrique en circuit imprimé. Selon la présente invention, le substrat de base (11; 11A) comporte au moins un canal (15; 15A, 15B) ménagé selon une direction d'écoulement (D), ce canal (15; 15A, 15B) étant destiné à assurer la circulation d'un fluide de refroidissement et à permettre un échange de chaleur entre le substrat (1) et le fluide de refroidissement.

## Description

La présente invention est relative à un substrat pour circuits imprimés destiné à permettre une évacuation efficace de la chaleur dissipée par des composants électroniques montés en surface, en particulier des composants électroniques de puissance. Plus particulièrement, la présente invention est relative à un substrat susceptible de recevoir un arrangement électrique en circuit imprimé et comportant un substrat de base réalisé en un matériau métallique thermiquement conducteur sur une face duquel sont disposés des moyens destinés, d'une part, à isoler électriquement l'arrangement électrique en circuit imprimé du substrat de base, et, d'autre part, à assurer un transfert vers le substrat de base de la chaleur dissipée par des composants électroniques montés sur l'arrangement électrique en circuit imprimé. Un substrat pour circuits imprimés répondant à cette définition est communément dénommé par l'appellation substrat métallique isolé ou SMI.

Dans la présente description, par "arrangement électrique en circuit imprimé" ou plus simplement "circuit imprimé" on entendra un arrangement électrique comprenant au moins un dépôt métallique conducteur placé sur un support électriquement isolant ou support diélectrique. On emploiera indifféremment ces termes pour désigner des circuits imprimés simple face, à savoir des arrangements électriques comportant un unique dépôt métallique conducteur, ou pour désigner des circuits imprimés double face ou multicouches, à savoir des arrangements électriques comportant deux ou plusieurs dépôts métalliques séparés les uns des autres par des supports diélectriques.

Il est maintenant courant de réaliser des cartes ou plaquettes à circuit imprimé pour de multiples et diverses applications. De telles plaquettes comportent typiquement un arrangement électrique en circuit imprimé sur lequel sont montés des composants électroniques. Ces composants électroniques, communément dénommés composants électroniques montés en surface ou composants SMD (Surface-Mount Device), sont couramment montés sur ces arrangements en circuit imprimé avec une densité grandissante et sont de plus en plus caractérisé par des puissances de fonctionnement importantes. Il est ainsi devenu crucial de disposer de supports ou substrats non seulement capables de résister à la chaleur dissipée par les composants électroniques montés en surface mais surtout capables d'évacuer efficacement et rapidement cette chaleur.

Il a ainsi été développé une technologie particulière pour répondre à ce problème. Cette technologie, dénommée technologie SMI (Substrat Métallique Isolé) consiste à utiliser un substrat dit substrat métallique isolé comprenant un substrat de base réalisé en un matériau métallique thermiquement conducteur sur une face duquel est déposée une couche ou une superposition de couches spécifiques destinées à recevoir l'arrangement électrique formant le circuit imprimé. Cette ou ces couches spécifiques forment des moyens permettant, d'une part, d'isoler électriquement l'arrangement électrique en circuit imprimé du substrat de base, et, d'autre part, d'assurer un transfert vers ce substrat de base de la chaleur dissipée par les composants électroniques montés sur l'arrangement électrique. Dans la suite de la description on qualifiera ces moyens de moyens d'isolation électrique et de conduction thermique.

Dans une plaquette à circuit imprimé SMI, la chaleur dissipée par les composants électroniques montés sur l'arrangement électrique en circuit imprimé est ainsi transmise par le biais des moyens d'isolation électrique et de conduction thermique dans le substrat de base tout en assurant une bonne isolation électrique entre le circuit imprimé et le substrat de base.

Dans sa plus simple réalisation, les moyens d'isolation électrique et de conduction thermique comprennent une unique couche constituée par exemple d'un film polyimide(amide) ou d'une résine époxy contenant des particules favorisant une bonne conductibilité thermique, telles notamment des fibres de verre ou des particules céramiques. Cette couche est rendue solidaire du substrat de base par pressage à chaud ou par l'utilisation, si nécessaire, d'un film adhésif.

Ces moyens peuvent toutefois être constitués d'une superposition de diverses couches ayant séparément ou en combinaison des propriétés isolantes du point de vue électrique et conductrices du point de vue thermique. Ces diverses couches peuvent également être rendues solidaires les unes des autres par pressage à chaud ou par l'utilisation de films adhésifs.

Pour des applications à haute ou très haute puissance, le substrat de base peut s'avérer insuffisant pour évacuer suffisamment et assez rapidement la chaleur dissipée par les composants électroniques montés sur l'arrangement électrique en circuit imprimé. Dans un tel cas, les plaquettes à circuit imprimé employant la technologie SMI sont typiquement disposés sur un élément supplémentaire de dissipation thermique ou élément radiateur, le substrat de base étant mis en contact avec cet élément radiateur.

La présence de cet élément radiateur, qui présente de grandes dimensions, implique des opérations supplémentaires d'assemblage avec le circuit imprimé SMI. Par ailleurs, afin d'assurer une bonne transmission de la chaleur du substrat de base vers l'élément radiateur, il est indispensable de veiller à ce que le contact thermique entre ces éléments soit le meilleur possible. En pratique, on veille à ce que la planéité des surfaces en contact entre le substrat de base et l'élément radiateur soit aussi bonne que possible afin de limiter la présence de poches d'air entre ces surfaces. La présence de poches d'air entre les surfaces en contacts cause en effet une dégradation de l'échange de chaleur entre le substrat de base et l'élément radiateur. En pratique, on utilise ainsi également typiquement des huiles ou graisses thermiques, telle du silicone, disposées entre les surfaces de contact du substrat de base et de l'élément radiateur. Outre l'inconvénient lié à leur utilisation, ces graisses se détériorent avec l'âge et l'efficacité thermique de l'ensemble se dégrade ainsi avec le temps.

Un but de la présente invention est ainsi de proposer un substrat métallique isolé pour circuits imprimés, adapté en particulier aux applications à haute ou très haute puissance, qui ne présente pas les inconvénients susmentionnés, à savoir notamment un substrat métallique isolé pour circuits imprimés qui ne nécessite pas d'élément de dissipation thermique supplémentaire.

A cet effet, la présente invention a pour objet un substrat susceptible de recevoir un arrangement électrique en circuit imprimé dont les caractéristiques sont énumérées à la revendication 1.

Des modes de réalisation avantageux de la présente invention font l'objet des revendications dépendantes.

La solution préconisée par la présente invention permet ainsi de réaliser une plaquette à circuit imprimé SMI particulièrement adaptée aux applications à haute ou très haute puissance et qui présente, pour une efficacité similaire, un encombrement réduit par rapport aux structures connues de l'art antérieur qui emploient communément des éléments de dissipation thermique supplémentaires. La présente invention permet ainsi de s'affranchir de tels éléments supplémentaires et par là même d'éviter tout utilisation contraignante d'huiles ou de graisses thermiques.

Le substrat selon la présente invention peut en outre, de par sa faible épaisseur, être avantageusement manipulé par des machines conventionnelles de montage en surface de composants électroniques, ou tout du moins n'implique pas de modifications majeures et coûteuses de ces machines de montage. Le substrat selon la présente invention peut ainsi être manipulé tel que le serait un substrat métallique isolé conventionnel.

D'autres caractéristiques et avantages de l'invention apparaîtront plus clairement à la lecture de la description détaillée qui suit, faite en référence aux dessins annexés donnés à titre d'exemples non limitatifs et dans lesquels :
- la figure 1 illustre une vue en perspective d'une plaquette à circuit imprimé comportant un substrat métallique isolé selon la présente invention;
- la figure 2 est une vue en coupe de la plaquette à circuit imprimé de la figure 1;
- la figure 3 est une illustration d'un dispositif permettant d'intégrer dans un circuit de refroidissement un module électronique formé sur un substrat métallique isolé selon la présente invention;
- la figure 4 est une vue en perspective illustrant un autre exemple de réalisation d'un substrat selon la présente invention; et
- la figure 5 est une illustration d'un dispositif permettant d'intégrer dans un circuit de refroidissement un module électronique formé sur un substrat métallique isolé du type illustré à la figure 4.

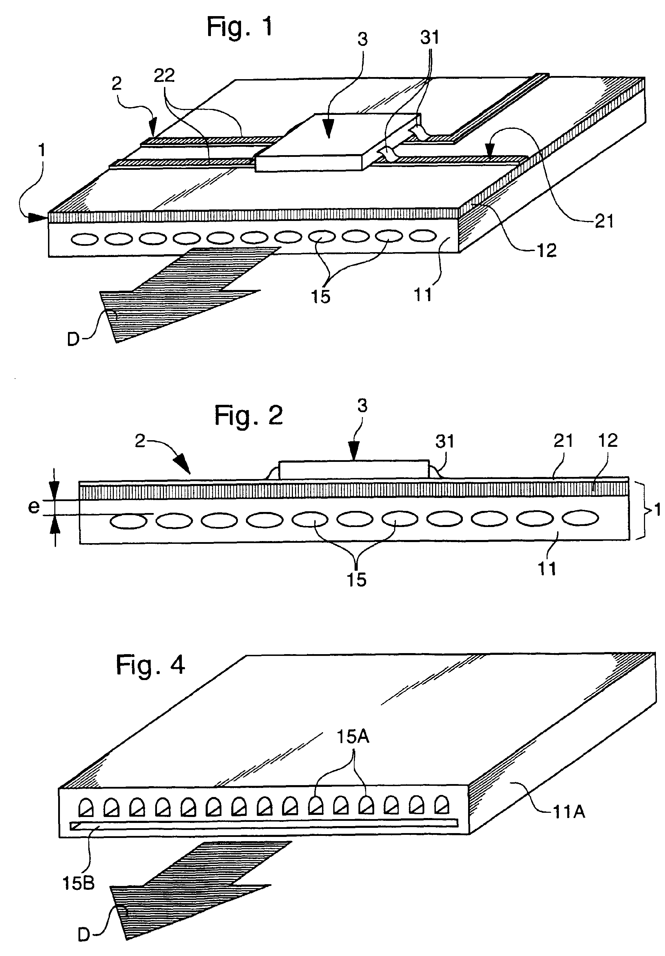

Les figures 1 et 2 illustrent un exemple d'une plaquette à circuit imprimé SMI comprenant un substrat constituant un premier exemple de réalisation de la présente invention. Dans ces figures, la référence numérique 1 désigne le substrat selon la présente invention et la référence numérique 2 désigne un arrangement électrique en circuit imprimé destiné à recevoir des composants électroniques montés en surface. A titre d'exemple, on a illustré, dans ces figures, un composant électronique 3 disposé sur la surface de l'arrangement électrique en circuit imprimé 2.

Le substrat 1 selon la présente invention comporte d'une part un substrat de base 11 réalisé en un matériau thermiquement conducteur et d'autre part des moyens d'isolation électrique et de conduction thermique, indiqués par la référence numérique 12, permettant d'assurer le transfert vers le substrat de base 11 de la chaleur dissipée par les composants électroniques. Dans l'exemple illustré aux figures 1 et 2, ces moyens 12 comprennent, disposée sur une face du substrat de base 11, une couche ayant à la fois des propriétés isolantes du point de vue électrique et conductrice du point de vue thermique.

On notera, comme on le verra plus tard, que des moyens d'isolation électrique et de conduction thermique peuvent avantageusement être disposés de part et d'autre du substrat de base 11 de sorte à permettre la disposition d'un arrangement électrique en circuit imprimé sur chacune des faces du substrat de la présente invention.

L'arrangement électrique en circuit imprimé 2 comporte un dépôt métallique conducteur 21 déposé sur la surface des moyens d'isolation électrique et de conduction thermique 12, et formant des pistes de connexion électrique 22 pour les composants électroniques. Le composant électronique 3 disposé sur la surface de l'arrangement électrique en circuit imprimé 2 comporte ainsi des pattes de connexion 31 respectivement connectées aux pistes de connexion électrique 22.

Le dépôt métallique conducteur 21 est préférablement réalisé en cuivre et peut par exemple être formé d'une feuille rendue solidaire du substrat ou être obtenu par électrodéposition. Des procédés conventionnels de formation de circuits imprimés, bien connus de l'homme du métier, permettent par ailleurs de former les pistes de connexion électrique 22 à partir de ce dépôt métallique.

Le substrat de base 11 peut être réalisé en un matériau bon conducteur du point de vue thermique tel un matériau métallique sélectionné dans le groupe de matériaux comprenant notamment l'aluminium AI, le cuivre Cu, l'acier, et des alliages ou combinaisons de ces matériaux. On notera que cette liste n'est pas exhaustive car d'autres matériaux équivalents présentant une bonne conductibilité thermique sont utilisables. En pratique, le substrat de base 11 est préférablement réalisé en aluminium car se matériau allie avantageusement un faible poids et une excellente conductibilité thermique.

Pour réaliser la couche formant les moyens d'isolation électrique et de conduction thermique 12, il convient par exemple d'utiliser une résine époxy ou un film polyimide(amide) chargé de particules favorisant une bonne conductibilité thermique tels des particules céramiques ou des fibres de verre par exemple.

On rappellera toutefois que les moyens d'isolation électrique et de conduction thermique 12 peuvent comprendre une pluralité de couches superposées ayant en combinaison des propriétés isolante du point de vue électrique et conductrice du point de vue thermique. On comprendra ainsi que des combinaisons de films époxy et de films polyimide(amide) peuvent être envisagées. Dans certains cas, des adhésifs utilisés pour rendre solidaire les différentes couches du substrat et du circuit imprimé peuvent en outre rentrer dans la composition de ces moyens d'isolation électrique et de conduction thermique.

Selon la présente invention, le substrat de base 11 comporte des moyens d'évacuation de la chaleur formés dans cet exemple d'une pluralité de canaux 15 ménagés dans le plan du substrat de base 11 et qui s'entendent selon une direction D ou direction d'écoulement indiquée par une flèche dans les figures.

Ces canaux 15 sont destinés à permettre la circulation d'un fluide de refroidissement, tel qu'un composé gazeux ou préférablement un liquide, de manière à assurer un échange de chaleur entre ce fluide de refroidissement et le substrat de base 11 et ainsi évacuer plus efficacement la chaleur transmise dans le substrat de base 11 par les composants électroniques montés en surface . De cette manière, le substrat de base 11 est soumis directement à l'action de refroidissement du fluide de refroidissement. La capacité d'évacuation thermique du substrat selon la présente invention est ainsi accrue.

Dans la figure 1, les canaux 15 sont ménagés dans l'épaisseur du substrat de base 11 et présentent de ce fait une section fermée. La section de ces canaux peut présenter des formes très diverses (sections elliptiques, oblongues, rectangulaires, polygonales, etc.). Plus particulièrement, la forme de ces canaux est déterminée, d'une part, par les besoins thermiques, à savoir la quantité de chaleur à évacuer du substrat, et, d'autre part, par le procédé de fabrication ou d'usinage du substrat.

Le substrat de base 11 peut par exemple très avantageusement être réalisé par un procédé conventionnel d'extrusion d'un profilé en matériau métallique. Ce procédé de fabrication permet en particulier de produire des plaques métalliques de grandes longueurs et de section constante à des coûts relativement peu élevés. On notera à ce titre que l'aluminium se prête particulièrement bien à ce type de procédé de fabrication.

Il est ainsi par exemple possible de réaliser un substrat de base en aluminium présentant des canaux de refroidissement de faible diamètre de l'ordre de 2 à 3 mm environ et dont l'épaisseur totale est de l'ordre de 10 à 20 mm. On notera que cette faible épaisseur du substrat de base rend ainsi possible la manipulation de l'ensemble par des machines conventionnelles de montage en surface de composants électroniques sans que des modifications de l'outil de production ne soient nécessaires ou tout du moins sans que des modifications importantes de cet outil de production ne soient nécessaires. En effet, à l'heure actuelle, les machines conventionnelles de production de plaquettes à circuit imprimé et de substrats métalliques isolés sont typiquement adaptées pour manipuler des ensembles pouvant atteindre 10 à 20 mm d'épaisseur.

Pour une efficacité similaire du point de vue thermique, on peut ainsi constater que le substrat selon la présente invention présente ainsi l'avantage d'être de plus faibles dimensions par rapport aux structures de l'art antérieur qui nécessitent l'adjonction d'un élément radiateur supplémentaire.

Par ailleurs, le substrat selon la présente invention présente une efficacité en termes d'évacuation de chaleur pouvant atteindre un facteur de 1 à 2 ordres de grandeur supérieur à l'efficacité d'un substrat SMI conventionnel lorsque le fluide de refroidissement utilisé est un liquide. L'application d'un gaz non forcé ou d'un gaz pulsé permet déjà d'augmenter sensiblement l'efficacité du substrat.

Afin de favoriser l'échange de chaleur entre le substrat et le fluide de refroidissement, on cherchera par ailleurs à maximiser le rapport surface/volume des canaux 15, c'est-à-dire à assurer une surface de contact aussi importante que possible entre le fluide de refroidissement et le substrat de base 11. Les canaux 15 présentent donc préférablement une section de faible surface et sont réalisés en grand nombre. On notera en outre que la réalisation de canaux de faible diamètre permet de favoriser un écoulement de régime turbulent du fluide de refroidissement.

Afin d'améliorer plus encore l'échange de chaleur entre le substrat de base 11 et le fluide de refroidissement, il est possible de réaliser des canaux dont la surface présente des aspérités permettant d'une part une certaine augmentation de la surface effective des canaux, donc un meilleur échange thermique, et favorisant, d'autre part, un régime turbulent du fluide de refroidissement. On notera à ce titre que le procédé d'extrusion peut avantageusement permettre la réalisation de canaux dont la surface est non uniforme.

On remarquera par ailleurs qu'il peut être envisageable de ne réaliser qu'un unique canal de refroidissement dans le substrat de base si les besoins en termes d'évacuation de chaleur ne sont pas trop importants.

La production par extrusion d'un profilé métallique est particulièrement adaptée pour réaliser un substrat de base présentant les caractéristiques susmentionnées. On notera cependant qu'il est envisageable de faire appel à d'autres techniques de fabrication pour réaliser un substrat de base comprenant des canaux de refroidissement. Par exemple, il serait envisageable de faire appel à un procédé de frittage, c'est-à-dire de moulage de poudres métalliques pour obtenir un substrat de base présentant des caractéristiques similaires.

Alternativement, on mentionnera qu'il est également possible d'usiner les canaux de manière conventionnelle, par exemple par fraisage, sur la face du substrat de base opposée à la face sur laquelle reposent les moyens d'isolation électrique et de conduction thermique, une plaque additionnelle étant alors rendue solidaire du substrat de base sur la face où sont formés ces canaux.

Les canaux 15 sont préférablement ménagés dans le substrat de base 11 de sorte à être distants de la face sur laquelle reposent les moyens d'isolation électrique et de conduction thermique 12 d'une distance déterminée e comme cela est illustré dans la figure 2. Cette distance e entre les canaux 15 et les moyens 12 définit une zone dans une première épaisseur du substrat de base 11 permettant d'accumuler momentanément la chaleur dissipée par les composants électroniques. Cette zone du substrat de base est ainsi destinée à jouer le rôle d'une masse thermique.

Les dimensions de cette masse thermique sont déterminées principalement en fonction de la puissance dissipée par les composants électroniques montés en surface ainsi que par la surface du circuit imprimé. Elle doit permettre de "drainer" rapidement la chaleur dissipée en surface par les composants électroniques, en particulier lorsque ceux-ci génèrent des échauffements de courte durée. En effet, si cette masse thermique est insuffisamment dimensionnée, la chaleur dissipée momentanément par les composants électroniques peut rester localisée en surface et causer des dommages au circuit imprimé et aux composants électroniques. La masse thermique assure ainsi que la chaleur dissipée par les composants électroniques montés en surface soit évacuée le plus rapidement de la surface du circuit imprimé pour être tout d'abord accumulée dans le substrat de base 11, puis être évacuée sous l'action du fluide de refroidissement circulant au travers des canaux 15.

A titre d'exemple, pour une surface de circuit de l'ordre d'une centaine de cm², et des puissances de l'ordre de 100 W à 10 kW, il convient de dimensionner cette masse thermique avec une épaisseur e de l'ordre de 2 à 5 mm.

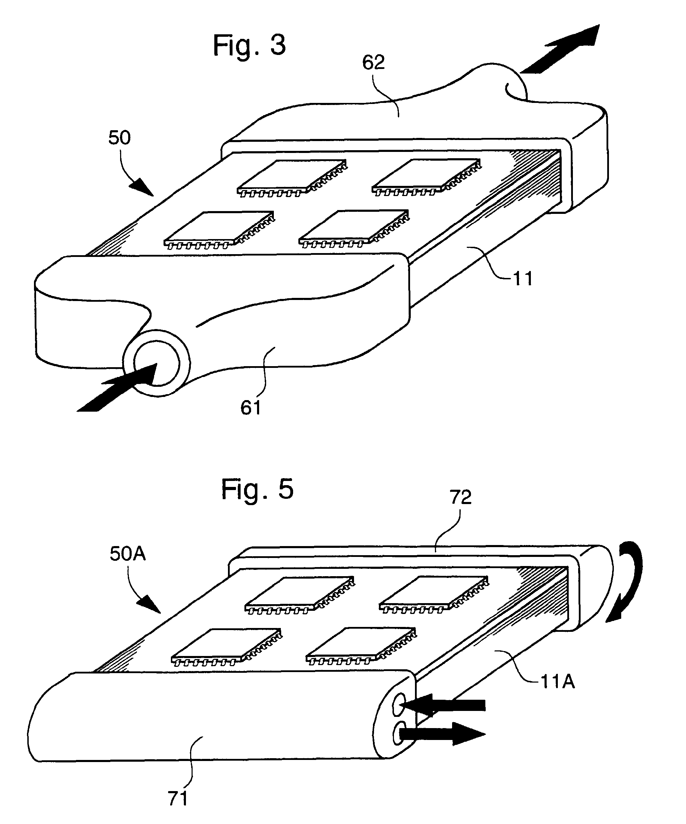

Au moyen de la figure 3, on décrira un dispositif permettant d'intégrer dans un circuit de refroidissement un module électronique, indiqué par la référence numérique 50, formé sur un substrat métallique isolé selon la présente invention.

Dans cet exemple, un connecteur d'entrée 61 est connecté à une extrémité du module électronique 50, et un connecteur de sortie 62 est connecté à l'autre extrémité du module 50, de telle sorte que la circulation d'un fluide de refroidissement dans la direction d'écoulement indiquée par la flèche est assurée au travers des canaux (non représentés dans cette figure) ménagés dans le substrat de base, indiqué par la référence numérique 11, du module 50.

Afin de réaliser ces connecteurs 61 et 62, il peut être envisageable, selon les besoins, de réaliser ceux-ci en matière plastique ou dans un matériau métallique. Dans ce dernier cas, il conviendra d'assurer l'étanchéité de l'ensemble par l'utilisation de joints et de moyens de fixation conventionnels ou en soudant ou brasant directement les connecteurs au substrat de base.

On remarquera par ailleurs qu'il est envisageable, si l'encombrement de l'ensemble le permet, de ne procéder au montage des composants qu'après avoir monté les connecteurs d'entrée et de sortie. Il est ainsi possible de produire un sous-ensemble semi-fini comportant les connecteurs d'entrée-sortie et la plaquette à circuit imprimé, à savoir le substrat métallique isolé sur lequel est disposé l'arrangement électrique en circuit imprimé, et de soumettre par la suite ce sous-ensemble au montage des composants en technologie SMT (Surface-Mount Technology).

La figure 4 illustre un autre exemple d'un substrat de base pouvant être envisagé dans le cadre de la présente invention. Cette figure illustre ainsi un substrat de base 11A comportant une pluralité de canaux 15A situés dans une partie supérieure du substrat de base 11A et au moins un canal 15B situés dans une partie inférieure du substrat de base 11A.

Comme on le verra ci-après, les canaux 15A sont destinés à assurer la circulation du fluide de refroidissement selon une première direction d'écoulement, et le canal 15B est destiné à assurer la circulation de ce fluide selon une direction opposée à cette direction d'écoulement. Les canaux 15A et 15B forment ainsi respectivement un trajet aller et un trajet retour pour le fluide de refroidissement traversant le substrat de base 11A.

La figure 5 illustre un dispositif permettant d'intégrer dans un circuit de refroidissement un module électronique, indiqué par la référence numérique 50A, formé sur un substrat métallique comprenant un substrat de base du type illustré à la figure 4 et indiqué par la même référence numérique 11A.

Dans cet exemple, un connecteur d'entrée-sortie 71 est connecté à l'une des extrémités du module 50A, et un connecteur de renvoi 72 est disposé à l'autre extrémité du module 50A. Le connecteur d'entrée-sortie 71 est agencé de manière à connecter, en entrée, les canaux situés dans la partie supérieure du substrat de base 11A du module 50A (à savoir les canaux 15A dans la figure 4) et, en sortie, le ou les canaux situés dans la partie inférieure du substrat de base 11A (à savoir le canal 15B dans la figure 4). Le connecteur de renvoi 72 permet d'assurer une connexion entre les canaux supérieurs et inférieurs du substrat.

Des observations similaires aux observations énoncées précédemment au sujet des connecteurs d'entrée 61 et de sortie et 62 de la figure 3 peuvent être formulées au sujet des connecteurs d'entrée-sortie 71 et de renvoi 72. En particulier, ces connecteurs peuvent par exemple être réalisés en matière plastique ou dans un matériau métallique.

On constatera qu'il est également envisageable d'utiliser un connecteur d'entrée-sortie et un connecteur de renvoi pour intégrer dans un circuit de refroidissement un module réalisé sur un substrat du type illustré aux figures 1 et 2. Dans ce cas, une partie des canaux sera utilisée pour assurer la circulation aller du fluide de refroidissement et l'autre partie des canaux sera utilisée pour assurer la circulation retour du fluide de refroidissement. Les connecteurs d'entrée-sortie et de renvoi seront naturellement réalisés de sorte à connecter les canaux de la manière adéquate.

On remarquera de manière générale que le substrat métallique isolé selon la présente invention permet avantageusement de s'affranchir de l'utilisation d'un élément radiateur additionnel, en particulier dans les applications à haute ou très haute puissance. La solution selon la présente invention permet ainsi de libérer les deux faces du substrat de base et autorise ainsi la disposition de deux arrangements électriques en circuit imprimé de part et d'autre du substrat métallique isolé ce qui n'était pas possible avec les solutions de l'art antérieur, ou tout du moins n'était pas possible à des encombrements aussi faibles.

De multiples modifications et/ou améliorations peuvent être apportées au substrat selon la présente invention sans sortir du cadre de celle-ci. On comprendra notamment que l'invention n'est pas limitée qu'aux modes de réalisations présentés dans la présente description et que diverses dispositions et géométries de canaux sont envisageables comme cela a déjà été mentionné.

## Revendications

1. Substrat (1) susceptible de recevoir un arrangement électrique en circuit imprimé (2), ce substrat (1) comportant :
- un substrat de base (11; 11A) réalisé en un matériau thermiquement conducteur, et
- au moins une couche formant des moyens d'isolation électrique et de conduction thermique (12) disposés sur au moins une face dudit substrat de base (11; 11A) et destinés, d'une part, à isoler électriquement ledit arrangement électrique en circuit imprimé (2) dudit substrat de base (11; 11A), et, d'autre part, à assurer un transfert vers ledit substrat de base (11; 11A) de la chaleur dissipée par des composants électroniques (3) montés sur ledit arrangement électrique en circuit imprimé (2),
caractérisé en ce que ledit substrat de base (11; 11A) comporte au moins un canal (15; 15A, 15B) ménagé selon une direction dite direction d'écoulement (D), ce canal (15; 15A, 15B) étant destiné à assurer la circulation d'un fluide de refroidissement et à permettre un échange de chaleur entre ledit substrat (1) et ledit fluide de refroidissement.

2. Substrat selon la revendication 1, caractérisé en ce que ledit canal (15; 15A, 15B) est ménagé dans l'épaisseur dudit substrat de base (11; 11A).

3. Substrat selon la revendication 1, caractérisé en ce que ledit canal est ménagé sur une face dudit substrat de base opposée à la face sur laquelle sont disposés lesdits moyens d'isolation électrique et de conduction thermique, une plaque additionnelle étant rendue solidaire dudit substrat de base sur la face où est formé ledit canal.

4. Substrat selon l'une quelconque des revendications 1 à 3, caractérisé en ce que ledit canal (15; 15A) est distant de la face sur laquelle sont disposés lesdits moyens d'isolation électrique et de conduction thermique (12) d'une distance (e) définissant une zone dans une première épaisseur dudit substrat de base (11; 11A) formant une masse thermique destinée à accumuler momentanément la chaleur dissipée par lesdits composants électroniques.

5. Substrat selon la revendication 4, caractérisé en ce que ledit canal (15; 15A) est distant de ladite face d'une distance (e) d'environ 2 à 5 mm.

6. Substrat selon la revendication 1, caractérisé en ce qu'au moins un premier canal (15A) forme un trajet aller dudit fluide de refroidissement, et qu'au moins un second canal (15B) forme un trajet retour dudit fluide de refroidissement.

7. Substrat selon la revendication 6, caractérisé en ce que ledit au moins premier canal (15A) est disposé dans une partie supérieure dudit substrat de base (11A) et ledit au moins second canal (15B) est disposé dans une partie inférieure dudit substrat de base (11A).

8. Substrat selon l'une quelconque des revendications 1 à 7, caractérisé en ce que lesdits moyens d'isolation électrique et de conduction thermique (12) comportent un film polyimide(amide) et/ou un film de résine époxy contenant des particules thermiquement conductrices.

9. Substrat selon l'une quelconque des revendications précédentes, caractérisé en ce qu'un dépôt métallique conducteur (21) est en outre disposé sur lesdits moyens d'isolation électrique et de conduction thermique (12).

10. Substrat selon la revendication 9, caractérisé en ce que des connecteurs (61, 62; 71, 72) permettant d'assurer le passage du fluide de refroidissement au travers dudit canal (15; 15A, 15B) sont connectés aux extrémités dudit substrat (1), ces connecteurs (61, 62; 71, 72) étant destinés à permettre l'intégration dudit substrat (1) dans un circuit de refroidissement.

11. Substrat selon la revendication 9, caractérisé en ce que ledit dépôt métallique conducteur (21) est réalisé en cuivre Cu.

12. Substrat selon l'une quelconque des revendications 1 à 11, caractérisé en ce que ledit substrat de base (11; 11A) est un profilé métallique extrudé ou un élément métallique fritté.

13. Substrat selon l'une quelconque des revendications précédentes, caractérisé en ce que ledit substrat de base (11; 11A) est réalisé en un matériau sélectionné parmi le groupe de matériaux comprenant l'aluminium AI, le cuivre Cu, l'acier, et les alliages ou combinaisons de ces matériaux.

14. Substrat de base (11; 11A) pour circuits imprimés destiné à recevoir, sur au moins une face dudit substrat de base (11; 11A), au moins une couche formant des moyens d'isolation électrique et de conduction thermique (12) susceptibles de recevoir un arrangement électrique en circuit imprimé (2) et destinés, d'une part, à isoler électriquement ledit arrangement électrique en circuit imprimé (2) dudit substrat de base (11; 11A), et, d'autre part, à assurer un transfert vers ledit substrat de base (11; 11A) de la chaleur dissipée par des composants électroniques (3) montés sur ledit arrangement électrique en circuit imprimé (2),
caractérisé en ce que ledit substrat de base (11; 11A) comporte au moins un canal (15; 15A, 15B) ménagé selon une direction dite direction d'écoulement (D), ce canal (15; 15A, 15B) étant destiné à assurer la circulation d'un fluide de refroidissement et à permettre un échange de chaleur entre ledit substrat (1) et ledit fluide de refroidissement.

15. Substrat de base selon la revendication 14, caractérisé en ce qu'au moins un premier canal (15A) forme un trajet aller dudit fluide de refroidissement, et qu'au moins un second canal (15B) forme un trajet retour dudit fluide de refroidissement.

16. Substrat de base selon la revendication 15, caractérisé en ce que ledit au moins premier canal (15A) est disposé dans une partie supérieure dudit substrat de base (11A) et ledit au moins second canal (15B) est disposé dans une partie inférieure dudit substrat de base (11A).

17. Substrat selon l'une quelconque des revendications 14 à 16, caractérisé en ce que ledit substrat de base (11; 11A) est un profilé métallique extrudé ou un élément métallique fritté.

18. Substrat selon l'une quelconque des revendications 14 à 17, caractérisé en ce que ledit substrat de base (11; 11A) est réalisé en un matériau sélectionné parmi le groupe de matériaux comprenant l'aluminium AI, le cuivre Cu, l'acier, et les alliages ou combinaisons de ces matériaux.

19. Module électronique en circuit imprimé caractérisé en ce qu'il est réalisé sur un substrat (1) selon l'une quelconque des revendications 1 à 13.

20. Module électronique selon la revendication 19, caractérisé en ce qu'il est connecté à un circuit de refroidissement au moyen d'une connecteur d'entrée (61) et d'un connecteur de sortie (62) respectivement disposés à chacune des extrémités dudit module, de manière à assurer la circulation du fluide de refroidissement aux travers d'au moins un canal (15) dudit substrat (1).

21. Module électronique selon la revendication 19, caractérisé en ce qu'il est connecté à un circuit de refroidissement au moyen d'un connecteur d'entrée-sortie (71) disposé à une extrémité dudit module et en ce qu'un connecteur de renvoi (72) est disposé à l'autre extrémité dudit module, de manière à ce qu'une circulation aller et une circulation retour du fluide de refroidissement soient respectivement assurées au travers d'au moins un premier (15A) et d'au moins un deuxième canal (15B) dudit substrat (1).
